# EUROPEAN PATENT APPLICATION

(11) **EP 4 709 059 A1**
(43) Date of publication of application: **11.03.2026**
(21) Application number: 25188201.5
(22) Date of filing: 08.07.2025
(51) Int. Cl.: H05K 1/02, H05K 3/32, G11C 16/10, G06F 13/42, H05K 1/11, H05K 1/18, H05K 3/34, G11C 5/04

(54) **INFORMATION PROCESSING APPARATUS, INFORMATION PROCESSING SYSTEM, WRITING JIG, AND WRITING METHOD**

(30) Priority: 10.09.2024 JP 2024156689
(71) Applicant: Lenovo (Singapore) Pte. Ltd., New Tech Park 556741 (SG)
(72) Inventor: YAMAGISHI, Takuo, Yokohama-shi, Kanagawa (JP); ITO, Ryosuke, Yokohama-shi, Kanagawa (JP); TAKAO, Minori, Yokohama-shi, Kanagawa (JP)
(74) Representative: Openshaw & Co.

(57) **Abstract**

The present invention provides an information processing apparatus which writes data into a plurality of SPI memory ICs without reducing reliability. The information processing apparatus includes a plurality of SPI memory ICs connected to a control unit by an SPI (Serial Peripheral Interface), and a printed board mounted with the SPI memory ICs. The printed board includes an expansion pad pattern which is a soldering pad pattern at a terminal of at least one of the SPI memory ICs and is arranged to extend around the IC so that a writing jig is connectable to the terminal, a through hole for positioning when connecting the writing jig to the terminal, and a conductor part connected to a chip select terminal of each of the SPI memory ICs so that one of the SPI memory ICs is selectable from the writing jig.

## Description

### BACKGROUND OF THE INVENTION

### Field of the Invention

The present invention relates to an information processing apparatus, an information processing system, a writing jig, and a writing method.

### Description of the Related Art

In an information processing apparatus such as a personal computer (PC), there has been known a technology of when data in an SPI (Serial Peripheral Interface) memory which stores a program of a BIOS (Basic Input Output System) or the like is corrupted, rewriting data into the SPI memory (refer to, for example, Japanese Unexamined Patent Application Publication No. 2022-41324). Further, in the prior art thereof, since it is necessary to incorporate a ROM writer into a printed board for the information processing apparatus, the prior art generally involves a method of directly connecting to a terminal of an SPI memory IC (Integrated Circuit) on the printed board of the information processing apparatus by a clip jig to write data therein, and a method of removing soldering of the SPI memory IC from the printed board to write data therein.

### SUMMARY OF THE INVENTION

However, in recent years, there has been a demand for larger SPI memory capacities, and information processing apparatuses mounted with a plurality of SPI memory ICs have appeared. In the method using the clip jig in the prior art described above, it is difficult to deal with the plurality of SPI memory ICs. The method of removing the soldering is time consuming and had the potential to reduce reliability due to the soldering.

The present invention has been made to solve the above problems, and its object is to provide an information processing apparatus, an information processing system, a writing jig, and a writing method capable of writing data into a plurality of SPI memory ICs without reducing reliability.

In order to solve the above-described problems, a first aspect of the present invention is an information processing apparatus which includes a plurality of SPI memory ICs connected to a control unit via an SPI (Serial Peripheral Interface), and a printed board mounted with the SPI memory ICs, and in which the printed board includes an expansion pad pattern which is a soldering pad pattern at a terminal of at least one of the SPI memory ICs and is arranged to extend around the IC so that a writing jig is connectable to the terminal, a through hole for positioning when connecting the writing jig to the terminal, and a conductor part connected to a chip select terminal of each of the SPI memory ICs so that one of the SPI memory ICs is selectable from the writing jig.

Also, according to the above-described aspect of present invention, in the above-described information processing apparatus, the positioning through hole has the conductor part, and the writing jig may determine a position to be connected to the terminal via the positioning through hole and select the chip select terminal of one of the SPI memory ICs via the positioning through hole.

Further, according to the above-described aspect of present invention, in the above-described information processing apparatus, the SPI memory ICs are two SPI memory ICs, and the printed board has the two positioning through holes around the expansion pad pattern. The writing jig may set one of the two positioning through holes to a voltage in a selected state of the chip select terminal to select one of the two SPI memory ICs.

In addition, a second aspect of the present invention is an information processing system including the information processing apparatus described above, the writing jig, and a host device which is connected to the writing jig and transmits write data to the SPI memory ICs via the writing jig.

Furthermore, a third aspect of the present invention is a writing jig which is connected to an information processing apparatus including a plurality of SPI memory ICs connected to a control unit by an SPI (Serial Peripheral Interface), and a printed board mounted with the SPI memory ICs, in which the printed board includes an expansion pad pattern which is a soldering pad pattern at a terminal of at least one of the SPI memory ICs and is arranged to extend around the IC, a positioning through hole, and a conductor part connected to a chip select terminal of each of the SPI memory ICs so as to be able to select one of the SPI memory ICs, and which includes a selection switch part which selects one of the SPI memory ICs via the conductor part, and is connected to the terminal via the expansion pad pattern to determine a position to be connected to the terminal using the positioning through hole.

Moreover, a fourth aspect of the present invention is a method for writing write data into the SPI memory ICs of the information processing system described above, including the steps of allowing the writing jig to determine a position connected to the terminal using the positioning through hole and to be connected to the terminal via the expansion pad pattern, allowing the writing jig to select one of the SPI memory ICs via the conductor part, and allowing the host device to transmit write data to the selected one of the SPI memory ICs via the writing jig.

According to the above-described aspects of present invention, it is possible to write data into a plurality of SPI memory ICs without reducing reliability.

### BRIEF DESCRIPTION OF THE DRAWINGS

FIG. 1 is a view illustrating an example of a hardware configuration of a laptop PC according to the present embodiment;
FIG. 2 is a view illustrating a connection example of an SPI memory in the present embodiment;
FIG. 3 is a view illustrating an example of a board pattern of the SPI memory in the present embodiment;
FIG. 4 is a plan view illustrating a mounting example of the SPI memory in the present embodiment;
FIG. 5 is a cross-sectional view illustrating the mounting example of the SPI memory in the present embodiment;
FIG. 6 is a configuration view illustrating an example of an information processing system according to the present embodiment;
FIG. 7 is a view illustrating a selected example of a CS1 in a selection switch part according to the present embodiment;
FIG. 8 is a flowchart illustrating an example of a method of writing to the SPI memory according to the present embodiment; and
FIG. 9 is a view illustrating a mounting example of an SPI memory in a modification of the present embodiment.

### DESCRIPTION OF THE INVENTION

An information processing apparatus, an information processing system, a writing jig, and a writing method according to an embodiment of the present invention will hereinafter be described with reference to the drawings.

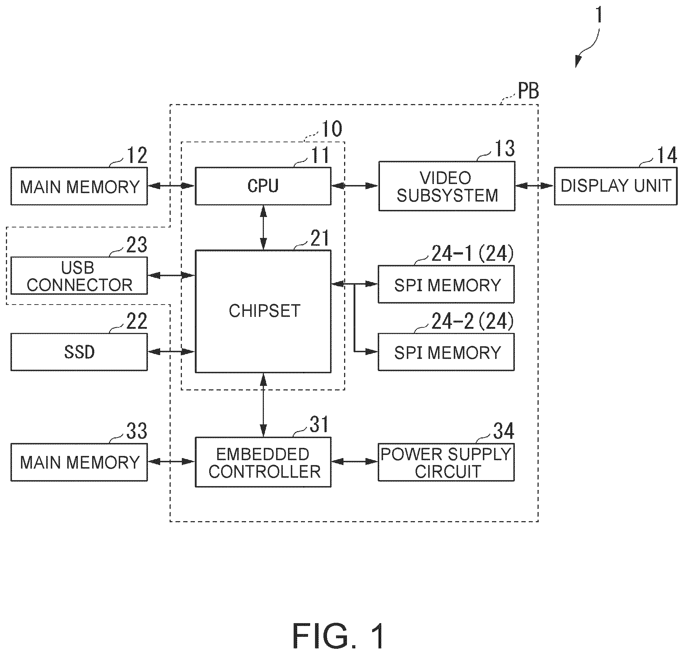

FIG. 1 is a view illustrating an example of a hardware configuration of a laptop PC 1 according to the present embodiment. As illustrated in FIG. 1, the laptop PC 1 includes a CPU 11, a main memory 12, a video subsystem 13, a display unit 14, a chipset 21, an SSD 22, a USB connector 23, SPI memories (24-1 and 24-2), an embedded controller 31, an input unit 33, and a power supply circuit 34.

Note that in the present embodiment, a notebook type personal computer (laptop PC 1) will be described as an example of the information processing apparatus.

Also, in the present embodiment, the CPU 11 and the chipset 21 correspond to a main control unit 10. Further, the main control unit 10 is an example of a control unit.

The CPU (Central Processing Unit) 11 executes various types of arithmetic processing by program control and controls the whole of the laptop PC 1.

The main memory 12 is a writable memory used as a reading area for an execution program of the CPU 11 or a working area for writing processing data of the execution program. The main memory 12 is constituted of, for example, a plurality of DRAM (Dynamic Random Access Memory) chips. The execution program includes a BIOS, an OS, various drives for operating peripheral devices by hardware, various services/utilities, application programs, etc.

Also, the main memory 12 is an example of a system memory which stores programs and data therein, and is installed in the laptop PC 1 by a DIMM mounted with a plurality of DRAMS.

The video subsystem 13 is a subsystem for realizing functions related to an image display and includes a video controller. This video controller processes a drawing command from the CPU 11, writes the processed drawing information into a video memory, reads the processed drawing information from the video memory, and outputs it to the display unit 14 as drawing data (display data).

The display unit 14 is, for example, a liquid crystal display and displays a display screen based on the drawing data (display data) output from the video subsystem 13.

The chipset 21 includes controllers such as a USB, a serial ATA (AT Attachment), an SPI (Serial Peripheral Interface) bus, a PCI (Peripheral Component Interconnect) bus, a PCI-Express bus, and an LPC (Low Pin Count) bus, and is connected with a plurality of devices. In FIG. 1, an SSD 22, a USB connector 23, and two SPI memories 24 are connected to the chipset 21 as examples of the devices.

The SSD (Solid State Drive) 22 (an example of a nonvolatile storage device) stores an OS, various drivers, various services/utilities, application programs, and various data.

The USB connector 23 is a connector for connecting peripheral devices which use a USB. The USB connector 23 includes, for example, a USB type-C connector.

The two SPI memories 24 (24-1, and 24-2) are configured by, for example, an electrically rewritable nonvolatile memory such as an EEPROM (Electrically Erasable Programmable Read Only Memory) or a flash ROM, and is accessible to the main control unit 10 using the SPI.

The two SPI memories 24 (24-1 and 24-2) store BIOS programs, BIOS setting information, etc.

Note that the SPI memories 24-1 and 24-2 are the same in configuration, and will be described as the SPI memory 24 when referring to any SPI memory included in the laptop PC 1, or when there is no particular distinction between the two.

The details of connection between the SPI memory 24 and the main control unit 10 will be described later.

The embedded controller 31 (an example of a sub-control unit) is a one-chip micon (One-Chip Microcomputer) which monitors and controls various devices (peripheral devices, sensors, etc.) regardless of a system state of the laptop PC 1. Also, the embedded controller 31 has a power supply management function of controlling the power supply circuit 34. Incidentally, the embedded controller 31 is constituted of a CPU, a ROM, a RAM, etc. not illustrated in the drawing, and includes A/D input terminals, D/A output terminals, timers, and digital input/output terminals for multiple channels. For example, the input unit 33, the power supply circuit 34, etc. are connected to the embedded controller 31 via those input/output terminals, and the embedded controller 31 controls the operations of these components.

The input unit 33 is, for example, an input device such as a keyboard, a pointing device, or a touchpad.

The power supply circuit 34 includes, for example, a DC/DC converter, a charge/discharge unit, a battery unit, an AC/DC adaptor, etc., and converts a DC voltage supplied from the AC/DC adaptor or the power unit into multiple voltages required to operate the laptop PC 1. Also, the power supply circuit 34 supplies power to each part of the laptop PC 1 under the control of the embedded controller 31.

A printed board PB is, for example, a motherboard, and is a printed circuit board for mounting main components of the laptop PC 1 thereon.

In the example illustrated in FIG. 1, the CPU 11, the video subsystem 13, the chipset 21, the SSD 22, the USB connector 23, the SPI memories (24-1 and 24-2), the embedded controller 31, and the power supply circuit 34 are assumed to be mounted on the printed board PB.

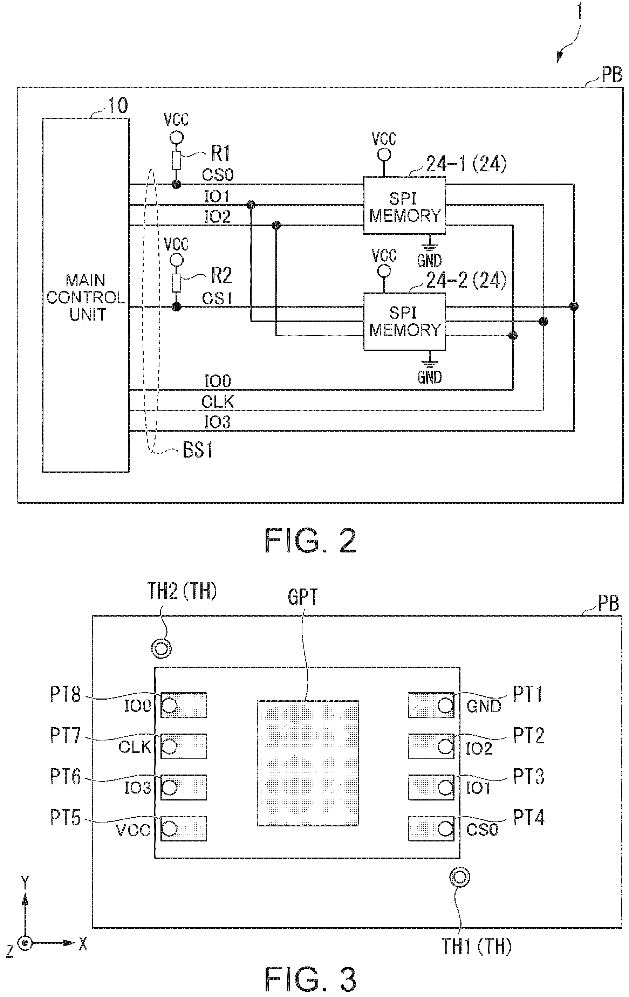

An example of connection of the SPI memories 24 in the present embodiment will next be described with reference to FIG. 2.

FIG. 2 is a view illustrating the example of connection of the SPI memories 24 in the present embodiment.

As illustrated in FIG. 2, the main control unit 10 and the two SPI memories 24 (24-1 and 24-2) are connected by the SPI bus BS1. Note that as described above, the main control unit 10 and the two SPI memories 24 (24-1 and 24-2) are mounted on the printed board PB.

The SPI bus BS1 has an I00 signal line, an IO1 signal line, an IO2 signal line, an IO3 signal line, and a CLK signal line (clock signal line), and has a CS0 signal line being a signal line for a CS signal (chip select signal) to select the SPI memory 24-1, and a CS1 signal line being a signal line for a CS signal to select the SPI memory 24-2.

Further, the CS0 signal line of the SPI memory 24-1 is pulled up to the voltage of a power supply VCC by a resistor R1. In addition, the CS2 signal line of the SPI memory 24-2 is pulled up to the voltage of the power supply VCC by a resistor R2.

Thus, ICs of the multiple (two) SPI memories 24 are connected to the main control unit 10 by the SPI.

The SPI memory 24-1 is selected and becomes accessible (e.g., available for writing data) when the CS0 signal line goes low (Low state).

Further, the SPI memory 24-2 is selected and becomes accessible (e.g., available for writing data) when the CS1 signal line goes into a low state.

Next, a board pattern of the SPI memory 24 and its mounting example will be described with reference to FIGS. 3 to 5.

FIG. 3 is a view illustrating an example of the board pattern of the SPI memory 24 in the present embodiment.

Here, a description will be made about a board pattern for mounting the SPI memory 24-1 which is one of the two SPI memories 24. Further, in the present embodiment, the SPI memory 24 is, for example, an IC for a WSON package or an IC for a leadless surface mounted package.

Further, in the present embodiment, the plane of the printed board PB is defined as an XY plane, and in FIG. 3, the horizontal axis direction on the paper is defined as an X direction, and the vertical axis direction on the paper is defined as a Y direction. In addition, the thickness direction of the printed board PB is defined as a Z direction.

As illustrated in FIG. 3, the printed board PB has a ground pattern GPT for mounting the SPI memory 24-1 by soldering, eight expansion pad patterns PTs (PT1 to PT8), and two positioning through holes THs (TH1 and TH2).

The ground pattern GPT is a conductor pattern on the printed board PB. The ground pattern GPT is a shielding ground pattern for the IC of the SPI memory 24-1 and is placed in the center of a mounting location for the IC of the SPI memory 24-1.

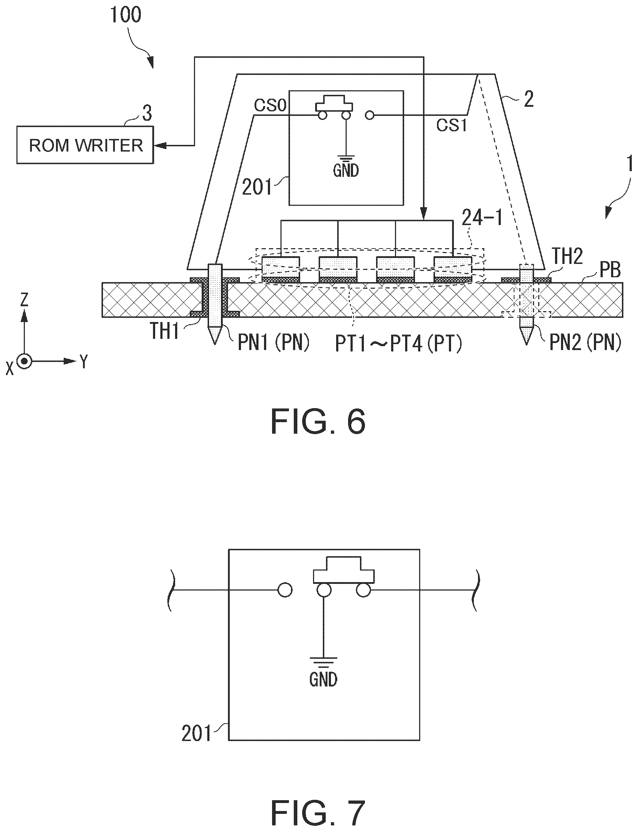

The expansion pad pattern PT is a solderable conductor pattern (metal pattern) on the printed board PB. The ground pattern GPT is a soldering pad pattern at each terminal of at least one (for the SPI memory 24-1) of the ICs of the two SPI memories 24, and is arranged to extend around the IC so that a writing jig 2 (refer to FIG. 6 to be described later) can be connected to the terminal of the SPI memory 24-1. The expansion pad pattern PT is, for example, a hood print pattern for soldering the IC of the SPI memory 24-1.

The expansion pad pattern PT1 is a pad pattern for soldering the GND terminal (ground terminal) of the IC of the SPI memory 24-1.

Also, the expansion pad pattern PT2 is a pad pattern for soldering the IO2 signal terminal of the IC of the SPI memory 24-1.

Further, the expansion pad pattern PT3 is a pad pattern for soldering the I01 signal terminal of the IC of the SPI memory 24-1.

Furthermore, the expansion pad pattern PT4 is a pad pattern for soldering the CS signal terminal (terminal to which the CS0 signal line is connected) of the IC of the SPI memory 24-1.

Moreover, the expansion pad pattern PT5 is a pad pattern for soldering the VCC terminal (power supply terminal) of the IC of the SPI memory 24-1.

In addition, the expansion pad pattern PT6 is a pad pattern for soldering the IO3 signal terminal of the IC of the SPI memory 24-1.

Furthermore, the expansion pad pattern PT7 is a pad pattern for soldering the CLK signal terminal (clock signal terminal) of the IC of the SPI memory 24-1.

Additionally, the expansion pad pattern PT8 is a pad pattern for soldering the IO0 signal terminal of the IC of the SPI memory 24-1.

Note that in the present embodiment, the expansion pad patterns PT1 to PT8 will be described as the expansion pad patterns PTs when they indicate any expansion pad patterns provided in the laptop PC 1 or when no particular distinction is made.

Also, in the present embodiment, the positioning through hole TH1 and the positioning through hole TH2 will be described as the positioning through hole TH when they indicate any positioning through holes provided in the laptop PC 1 or when no particular distinction is made.

The positioning through hole TH is a through hole for positioning when connecting a writing jig 2 to be described later to the terminal of the IC of the SPI memory 24-1. Further, the positioning through hole TH penetrates in the thickness direction (Z direction) of the printed board PB and is covered with a conductor thereinside. The positioning through hole TH also serves as a conductor part connected to each of the chip select terminals of the ICs of the two SPI memories 24 so that the writing jig 2 can select one of the ICs of the multiple SPI memories 24.

In the present embodiment, a description will be made about an example in which the positioning through hole TH also serves as the conductor part (conductor pattern) for selecting the SPI memory 24.

The positioning through hole TH1 is connected to the CS0 signal line (chip select signal line of the SPI memory 24-1) illustrated in FIG. 2, for example, and the positioning through hole TH2 is connected to the CS1 signal line (chip select signal of the SPI memory 24-2) illustrated in FIG. 2, for example.

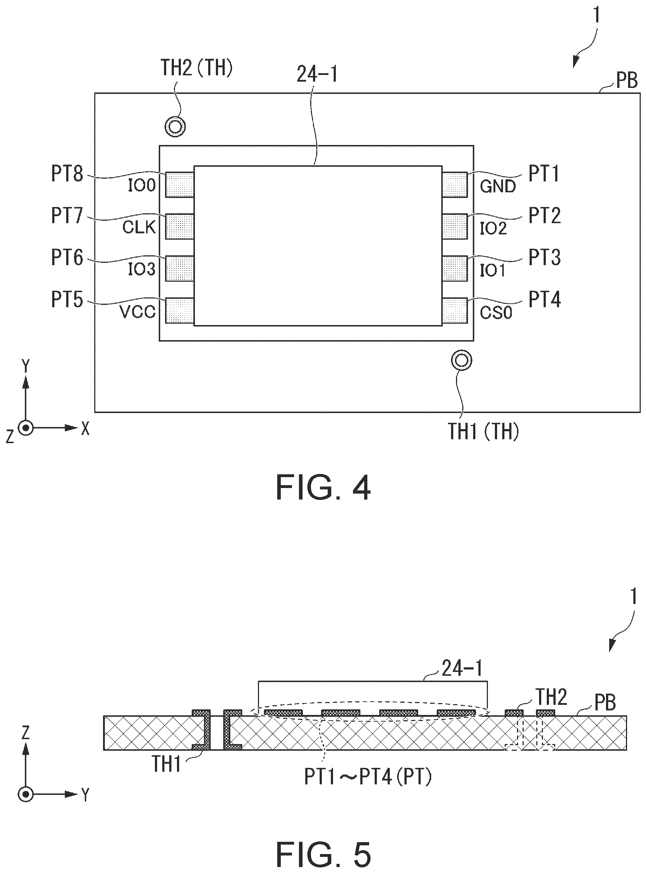

Next, a mounting example of the SPI memory in the present embodiment will be described with reference to FIGS. 4 and 5.

FIG. 4 is a plan view illustrating the mounting example of the SPI memory 24-1 in the present embodiment. Further, FIG. 5 is a cross-sectional view illustrating the mounting example of the SPI memory 24-1 in the present embodiment.

The example illustrated in FIG. 4 illustrates a state in which the IC of the SPI memory 24-1 is soldered to the printed board PB illustrated in FIG. 3. The SPI memory 24-1 is a WSON package, and after soldering, the expansion pad patterns PT1 to PT8 can be connected to the respective terminals of the SPI memory 24-1 by the writing jig 2.

Incidentally, of the multiple (for example, two) SPI memories 24, the SPI memory 24 (for example, the SPI memory 24-2) other than the SPI memory 24-1 is not illustrated, but is mounted in another location on the printed board PB. Further, the ICs of the SPI memories 24 other than the SPI memory 24-1 may be mounted at a location away from the IC of the SPI memory 24-1, or, for example, on the back surface of the printed board PB (the surface opposite to the surface on which the IC of the SPI memory 24-1 is mounted).

Further, as illustrated in FIG. 5, the inside of the positioning through hole TH is covered with a conductor (metal). The positioning through hole TH1 is connected to the CS0 signal line, and the positioning through hole TH2 is connected to the CS1 signal line.

Next, the information processing system 100 and the writing jig 2 according to the present embodiment will be described with reference to FIG. 6.

FIG. 6 is a configuration view illustrating an example of the information processing system 100 according to the present embodiment.

As illustrated in FIG. 6, the information processing system 100 includes a laptop PC 1, the writing jig 2, and a ROM writer 3. Incidentally, the example illustrated in FIG. 6 illustrates a state in which the writing jig 2 is connected to the printed board PB of the laptop PC 1 in the state illustrated in FIG. 5 described above.

The writing jig 2 is a writing jig 2 connected to the laptop PC 1, which is directly connected to the expansion pad pattern PT on which the SPI memory 24-1 is mounted, connects between the SPI memory 24-1 and the ROM writer 3, and selects one of the ICs of the multiple (two) SPI memories 24 via the positioning through hole TH (conductor part).

The writing jig 2 is connected so as to cover the IC of the SPI memory 24-1 mounted on the printed board PB. The writing jig 2 is connected to the terminal of the SPI memory 24-1 via the expansion pad pattern PT to determine the position where it is connected to the terminal of the SPI memory 24-1 using the positioning through hole TH.

The writing jig 2 includes two positioning pins PNs (PN1 and PN2), a connection terminal part CT, and a selection switch part 201.

The positioning pin PN is inserted into the positioning through hole TH to determine a connection position of the writing jig 2.

Further, the positioning pin PN is connected to the selection switch part 201 within the writing jig 2 and is used to select a CS signal (chip select signal) (selection of the SPI memory 24).

The CS0 signal line is connected to the positioning pin PN1 via the positioning through hole TH1. The CS1 signal line is connected to the positioning pin PN2 via the positioning through hole TH2.

The selection switch part 201 selects one of the ICs of the two SPI memories 24 via the positioning through hole TH (conductor part). The selection switch part 201 connects either the CS0 signal line or the CS1 signal line to a GND line to select one of the ICs of the two SPI memories 24.

The selection switch part 201 selects the SPI memory 24-1 when such a CS0 signal line as illustrated in FIG. 6 is in a state of being connected to the GND line.

Further, the selection switch part 201 selects the SPI memory 24-2 when such a CS1 signal line as illustrated in FIG. 7 is in a state of being connected to the GND line.

Incidentally, FIG. 7 is a view illustrating a selected example of the CS1 in the selection switch part 201 according to the present embodiment. As illustrated in FIG. 7, the selection switch part 201 connects the CS1 signal line and the GND line to thereby select the SPI memory 24-2.

Returning to the description of FIG. 6, the connection terminal part CT is electrically connected to each terminal of the SPI memory 24 by contacting the expansion pad pattern PT (each of PT1 to PT8) or the solder on the expansion pad pattern PT, and connects each signal line of the SPI memory 24 to the ROM writer 3.

The ROM writer 3 (one example of a host device) is connected to the SPI memory 24 via the writing jig 2 and transmits data (for example, image data of the BIOS program) to the SPI memory 24 as write data, thereby writing (storing) the data into the SPI memory 24.

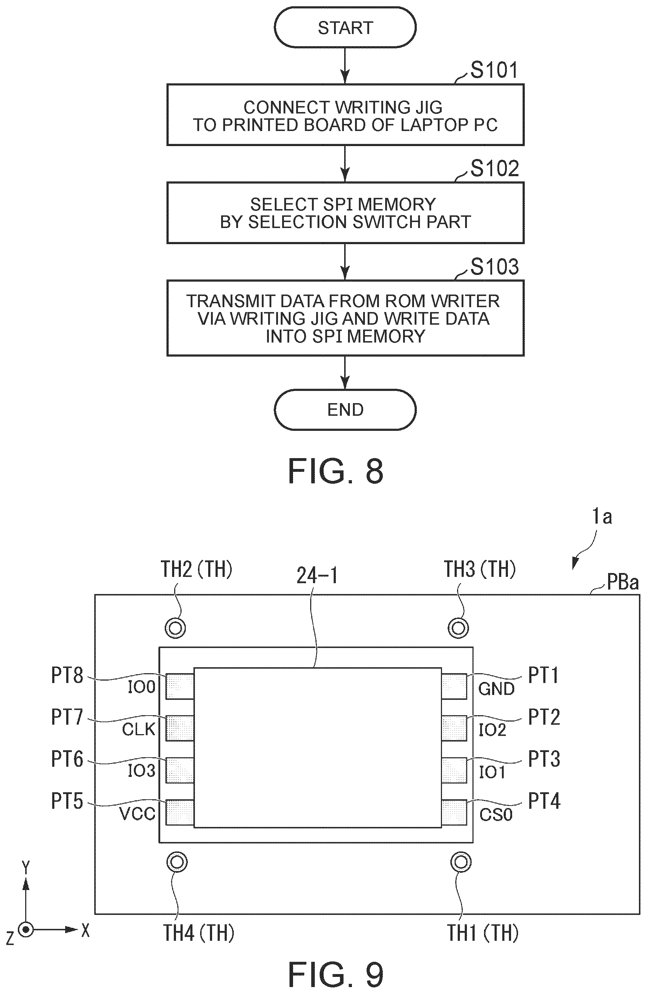

Next, a method of writing to the SPI memory 24 according to the present embodiment will be described with reference to FIG. 8.

FIG. 8 is a flowchart illustrating an example of the method of writing to the SPI memory 24 according to the present embodiment.

As illustrated in FIG. 8, in the writing method according to the present embodiment, first, the writing jig 2 is connected to the printed board PB of the laptop PC (Step S101). That is, the writing jig 2 determines the position where it is connected to the terminal of the IC of the SPI memory 24-1 using the positioning through hole TH, and is connected to the terminal of the IC of the SPI memory 24-1 via the expansion pad pattern PT (refer to FIG. 6, for example).

Next, the selection switch part 201 selects the SPI memory 24 (Step S102). That is, the writing jig 2 selects one of the two SPI memories 24. Here, as illustrated in FIG. 6, when the CS0 signal line and the GND line are connected by the selection switch part 201, the SPI memory 24-1 is selected, and as illustrated in FIG. 7, when the CS1 signal line and the GND line are connected by the selection switch part 201, the SPI memory 24-2 is selected.

Next, the ROM writer 3 transmits data via the writing jig 2 and writes the data into the SPI memory 24 (Step S103). That is, the ROM writer 3 transmits write data to the selected one of the two SPI memories 24 via the writing jig 2, and writes the data (data such as the BIOS program, for example) into the SPI memory 24. After the processing of Step S103, the ROM writer 3 ends the processing.

As described above, the laptop PC 1 (information processing apparatus) according to the present embodiment includes the ICs of the multiple (e.g., two) SPI memories 24 (SPI memory ICs) and the printed board PB on which the ICs of the multiple SPI memories 24 are mounted. The ICs of the SPI memories 24 are connected to the main control unit 10 (controller) by the SPI. The printed board PB includes the expansion pad patterns PTs (PT1 to PT8), the through holes THs (TH1 and TH2), and the conductor parts (e.g., the positioning through holes THs). The expansion pad pattern PT is the soldering pad pattern at each terminal of at least one of the ICs of the multiple SPI memories 24, which is arranged to extend around the IC so that the writing jig 2 can be connected to the terminal of the IC of the SPI memory 24. The through hole TH is the through hole for positioning when connecting the writing jig 2 to the terminal of the IC of the SPI memory 24. The conductor part (positioning through hole TH) is connected to the chip select terminal (CS signal terminal) of each of the ICs of the multiple SPI memories 24 so that one of the ICs of the multiple SPI memories 24 can be selected from the writing jig 2.

Thus, in the laptop PC 1 (information processing apparatus) according to the present embodiment, the expansion pad pattern PT makes it possible to easily connect the writing jig 2 to the SPI memory 24. Further, the positioning through hole TH (conductor part) makes it possible to select one of the ICs of the multiple SPI memories 24. Therefore, for example, since there is no need to peel off the soldering of the SPI memory 24 to write data, the laptop PC 1 (information processing apparatus) according to the present embodiment can appropriately write data into the ICs of the multiple SPI memories 24 without reducing reliability.

Further, in the present embodiment, the positioning through hole TH has the above-described conductor part. The writing jig 2 determines the position to be connected to the terminal of the IC of the SPI memory 24 via the positioning through hole TH, and selects the CS signal terminal (chip select terminal) of one of the ICs of the multiple SPI memories 24 via the positioning through hole TH.

Thus, since the laptop PC 1 according to the present embodiment serves as both the positioning through hole TH and the conductor part for connecting the CS signal line to select the SPI memory 24, it is possible to reduce a mounting space for the SPI memory 24 on the printed board PB and miniaturize the writing jig 2.

In addition, in the present embodiment, the ICs of the multiple SPI memories 24 are the ICs of the two SPI memories 24. The printed board PB has the two positioning through holes THs around the expansion pad patterns PTs. In the laptop PC 1, one of the ICs of the two SPI memories 24 is selected by setting one of the two positioning through holes THs to the voltage (e.g., low state) in the selected state of the CS signal terminal (chip select terminal) using the writing jig 2.

Thus, the laptop PC 1 according to the present embodiment can easily select one of the ICs of the two SPI memories 24 using the positioning through hole TH.

Further, the information processing system 100 according to the present embodiment includes the above-described laptop PC 1, writing jig 2, and ROM writer 3 (host device). The ROM writer 3 (host device) is connected to the writing jig 2 and transmits the write data to the ICs of the multiple SPI memories 24 via the writing jig 2.

As a result, the information processing system 100 according to the present embodiment can bring about the same effect as the above-described laptop PC 1 and is capable of appropriately writing data into the ICs of the multiple SPI memories 24 without reducing reliability.

In addition, the writing jig 2 according to the present embodiment denotes the writing jig 2 connected to the laptop PC 1 having the ICs of the multiple SPI memories 24 connected to the main control unit 10 (controller) by SPI, and the printed board PB mounted with the ICs of the multiple SPI memories 24, and includes the selection switch part 201. Incidentally, the printed board PB includes the expansion pad pattern PT which is the soldering pad pattern at the terminal of at least one of the ICs of the multiple SPI memories 24 and is arranged to extend around the IC, the positioning through hole TH, and the conductor part connected to the chip select terminal of each of the ICs for the multiple SPI memories 24 so that one of the ICs of the multiple SPI memories 24 can be selected. The selection switch part 201 selects one of the ICs of the multiple SPI memories 24 via the positioning through hole TH (conductor part). Further, the writing jig 2 is connected to the terminal via the expansion pad pattern PT to determine the position to connect to the terminal using the positioning through hole TH.

As a result, the writing jig 2 according to the present embodiment can bring about the same effect as the above-described laptop PC 1 and information processing system 100 and is capable of appropriately writing data into the ICs of the multiple SPI memories 24 without reducing reliability.

Further, the writing method according to the present embodiment is a method of writing write data into the ICs of the multiple (two) SPI memories 24 of the information processing system 100 described above, and includes a connecting step, a selecting step, and a transmitting step. In the connecting step, the writing jig 2 determines the position where it is connected to the terminal of the IC of the SPI memory 24 using the positioning through hole TH, and is connected to the terminal of the IC of the SPI memory 24 via the expansion pad pattern PT. In the selecting step, the writing jig 2 selects one of the ICs of the multiple SPI memories 24 via the positioning through hole TH (conductor part). In the transmitting step, the ROM writer 3 (host device) transmits write data to the selected one of the ICs of the multiple SPI memories 24 via the writing jig 2.

As a result, the writing method according to the present embodiment can bring about the same effect as the above-described laptop PC 1 and information processing system 100 and is capable of appropriately writing data into the ICs of the multiple SPI memories 24 without reducing reliability.

Next, a description will be made about a modification of the present embodiment with reference to the drawings.

Although the example in which the laptop PC 1 includes the two SPI memories 24 has been described in the present embodiment, the present invention is not limited to this and may include three or more SPI memories. Therefore, as the modification of the present embodiment, a description will be made about an example in which four SPI memories 24 are provided.

FIG. 9 is a view illustrating a mounting example of a SPI memory 24-1 in the modification of the present embodiment.

In the present modification, although not illustrated, a laptop PC 1a includes four SPI memories 24 (SPI memories 24-1 to 24-4).

In the mounting example of the SPI memory 24-1 illustrated in FIG. 9, a board BPa of the laptop PC 1a includes four positioning through holes THs.

The positioning through hole TH1 is connected to a CS0 signal line for selecting the SPI memory 24-1. Also, the positioning through hole TH2 is connected to a CS1 signal line for selecting the SPI memory 24-2.

Further, the positioning through hole TH3 is connected to a CS2 signal line for selecting the SPI memory 24-3. In addition, the positioning through hole TH4 is connected to a CS3 signal line for selecting the SPI memory 24-4.

In the present modification, the writing jig 2 is capable of selecting one of the CS0 to CS3 signal lines by connecting it to the ground line using the four positioning through holes THs.

Incidentally, in the example illustrated in FIG. 9, the number of SPI memories 24 is four, but if four or more positioning through holes TH1 are provided, it is also possible to accommodate a laptop PC 1 (1a) having four or more SPI memories 24. The number of SPI memories 24 may be three.

Note that the present invention is not limited to the above-described embodiment, and can be modified within the scope not departing from the spirit of the present invention.

For example, in the printed board PB (PBa) according to the above-described embodiment, there has been described the example in which the positioning through hole TH1 also serves as the pad pattern (conductor part) connected to the chip select terminal (CS signal terminal) of each of the ICs for the multiple SPI memories 24 in order to select one of the multiple SPI memories 24, but the present invention is not limited to this. The pad pattern (conductor part) may be provided separately from the positioning through hole TH1.

Further, in the above-described embodiment, there has been described the example in which the information processing apparatus is the laptop PC 1, but the information processing apparatus is not limited to this and may be, for example, another information processing apparatus such as a tablet terminal device or a desktop PC.

In addition, in the above-described embodiment, there has been described the example in which the main control unit 10 and the multiple SPI memories 24 are connected, but the present invention is not limited to this. The main control unit 10 and the multiple SPI memories 24 may be connected via the embedded controller 31 (sub-control unit). Also, in this case, the embedded controller 31 (sub-control unit) may serve as the control unit. Description of Symbols
1, 1a laptop PC
2 writing jig
3 ROM writer
10 main control unit
11 CPU
12 main memory
13 video subsystem
14 display unit
21 chipset
22 SSD
23 USB connector
24, 24-1, 24-2 SPI memory
33 input unit
34 power supply circuit
100 information processing system
201 selection switch part
CT connection terminal part
PB, PBa printed board
PT0 ground pattern
PT1, PT2, PT3, PT4, PT5, PT6, PT7, PT8 expansion pad pattern
TH, TH1, TH2 through hole

## Claims

1. An information processing apparatus comprising:
a plurality of SPI memory ICs connected to a control unit by an SPI (Serial Peripheral Interface); and
a printed board mounted with the SPI memory ICs,
wherein the printed board comprises:
an expansion pad pattern which is a soldering pad pattern at a terminal of at least one of the SPI memory ICs and is arranged to extend around the IC so that a writing jig is connectable to the terminal;
a through hole for positioning when connecting the writing jig to the terminal; and
a conductor part connected to a chip select terminal of each of the SPI memory ICs so that one of the SPI memory ICs is selectable from the writing jig.

2. The information processing apparatus according to claim 1, wherein the positioning through hole comprises the conductor part, and
wherein the writing jig is configured to determine a position to be connected to the terminal via the positioning through hole and to select the chip select terminal of one of the SPI memory ICs via the positioning through hole.

3. The information processing apparatus according to claim 2, wherein the SPI memory ICs are two SPI memory ICs,
wherein the printed board comprises the two positioning through holes around the expansion pad pattern, and
wherein the writing jig is configured to set one of the two positioning through holes to a voltage in a selected state of the chip select terminal to select one of the two SPI memory ICs.

4. An information processing system comprising:
an information processing apparatus according to any one of claims 1 to 3;
a writing jig; and
a host device connectable to the writing jig and configured to transmit write data to the SPI memory ICs via the writing jig.

5. A writing jig connectable to an information processing apparatus, the information processing apparatus comprising a plurality of SPI memory ICs connected to a control unit by an SPI (Serial Peripheral Interface), and a printed board mounted with the SPI memory ICs,
wherein the printed board comprises an expansion pad pattern which is a soldering pad pattern at a terminal of at least one of the SPI memory ICs and is arranged to extend around the IC, a positioning through hole, and a conductor part connected to a chip select terminal of each of the SPI memory ICs so as to be able to select one of the SPI memory ICs,
wherein the writing jig comprises a selection switch part configured to select one of the SPI memory ICs via the conductor part, and
wherein the writing jig is connectable to the terminal via the expansion pad pattern to determine a position to be connected to the terminal using the positioning through hole.

6. A method for writing write data into the SPI memory ICs of the information processing system according to claim 4, of the method comprising:
determining a position for a writing jig to be connected to the terminal using the positioning through hole and to be connected to the terminal via the expansion pad pattern;
selecting one of the SPI memory ICs via the conductor part; and
transmitting write data to the selected one of the SPI memory ICs via the writing jig.
